# EUROPÄISCHE PATENTSCHRIFT

(11) **EP 1 779 428 B1**
(45) Veröffentlichungstag und Bekanntmachung des Hinweises auf die Patenterteilung: **27.05.2015**
(21) Anmeldenummer: 05770056.9
(22) Anmeldetag: 20.07.2005
(51) Int. Cl.: H01L 23/498, H01L 23/00, H05K 1/02, H05K 1/11

(54) **VERFAHREN ZUR HERSTELLUNG EINES VERDRAHTUNGSSUBSTRATS EINES HALBLEITERBAUTEILS MIT AUSSENKONTAKTANSCHLUSSFLECKEN FÜR AUSSENKONTAKTE**
METHOD FOR PRODUCING A WIRING SUBSTRATE OF A SEMICONDUCTOR COMPONENT COMPRISING EXTERNAL CONTACT PADS FOR EXTERNAL CONTACTS
PROCEDE DE REALISATION D'UN SUPPORT DE CABLAGE D'UN ELEMENT SEMI-CONDUCTEUR COMPORTANT DES ZONES DE RACCORDEMENT POUR DES CONTACTS EXTERNES

(30) Priorität: 19.08.2004 DE 102004040414
(43) Veröffentlichungstag der Anmeldung: 02.05.2007
(73) Patentinhaber: Infineon Technologies AG, 85579 Neubiberg (DE)
(72) Erfinder: BAUER, Michael, 93152 Nittendorf (DE); STEINER, Rainer, 93049 Regensburg (DE); WÖRNER, Holger, 93049 Regensburg (DE)
(74) Vertreter: Schäfer, Horst
(86) Internationale Anmeldenummer: PCT/DE2005/001278
(87) Internationale Veröffentlichungsnummer: WO 2006/017998

(56) Entgegenhaltungen:
- DE-A1- 10 134 011
- US-A- 5 900 674
- US-A1- 2002 192 865
- US-A1- 2003 121 698
- US-A1- 2003 201 534
- US-A1- 2004 147 060
- US-B1- 6 265 245
- US-B1- 6 399 896

## Beschreibung

Die Erfindung betrifft ein Verfahren zur Herstellung eines Verdrahtungssubstrats eines Halbleiterbauteils mit Außenkontaktanschlussflecken für Außenkontakte . Dabei sollen vorzugsweise als Außenkontakte Lotkugeln auf die Außenkontaktanschlussflecken aufgebracht werden.

Derartige Verdrahtungssubstrate werden für Halbleiterbauteilgehäuse verwendet, die auch als BGA-Gehäuse (Ball Grid Array) oder als LBGA-Gehäuse (Large Ball Grid Array) bekannt sind.

Eines der Probleme dieser Verdrahtungssubstrate ist die Zuverlässigkeit, mit der eine Verbindung zwischen den Außenkontaktanschlussflecken des Verdrahtungssubstrats und einer übergeordneten Schaltungsplatine hergestellt werden kann. Bei zyklischen thermischen Belastungen werden aufgrund des Vorliegens unterschiedlicher Materialien mit unterschiedlichen thermischen Ausdehnungskoeffizienten zyklische mechanische Scherbelastungen auf die Lotverbindungen ausgeübt. Bei Vibrationsbelastungen kommen zusätzlich zu den Scherbelastungen der zyklischen thermischen Beanspruchungen noch Druckschwankungen hinzu, die in der Summe zu Mikrorissen oder zum Versagen der Verbindung führen können.

Im Stand der Technik werden viele unterschiedliche Verfahren verwendet, um die Zuverlässigkeit der Lotballverbindungen mit übergeordneten Schaltungsplatinen zu verbessern. Einige Verfahren basieren auf der Gestaltung der Lotverbindungen, um die mechanische Belastung zu vermindern. Andere Verfahren versuchen die Materialeigenschaften der Gehäusepackungen derart anzupassen, dass diese mechanischen Belastungen vermindert werden, wie z.B. durch Einfügen von Halbleiterchipklebstoffschichten. Einige dieser Lösungen haben den Nachteil, dass die Anpassung der Gehäusesubstrate sehr stark von der spezifischen Ausführungsform der Gehäuse abhängig ist. Diese Lösungen erfordern zusätzliche komplexe und teure Fertigungsverfahren. Diese Probleme vergrößern sich noch, wenn zu kleineren Abständen zwischen den Lötkontakten und zu kleineren Anschlussrastermaßen übergegangen wird.

Außerdem wird ein Übergang von bleihaltigen zu bleifreien Lotmaterialien aufgrund unterschiedlicher Eigenschaften der jeweiligen Materialien die Probleme in Bezug auf die Belastungsgrenzen von Lotkugeln als Außenkontakte nicht vermindern sondern eher erhöhen. Weitere Möglichkeiten die Probleme zu lösen, bestehen darin, ein zusätzliches Material in Form eines Underfillers zwischen das Verdrahtungssubstrat des Gehäuses und der übergeordneten Schaltungsplatine zu bringen. Dieses erfordert aber einen zusätzlichen Prozessschritt beim Herstellen von Schaltungsplatinen und erschwert ein Auswechseln oder Instandsetzen von Baugruppen auf den Schaltungsplatinen.

Weitere Lösungsansätze im Stand der Technik sehen vor, dass die Kontakte selbst flexibel ausgeführt werden, z.B., indem die Außenkontakte Federelemente bilden oder aus flexiblen Materialien in Form von Elastomerbällen mit gummielastischen Kernen ausgeführt werden. Jedoch sind diese Varianten mit flexiblen Kontakten sehr kostenintensiv und für die Massenfertigung ungeeignet. Außerdem ergeben sich Zuverlässigkeitsprobleme durch die geringe Robustheit dieser Federelemente oder Elastomerbälle als Außenkontakte.

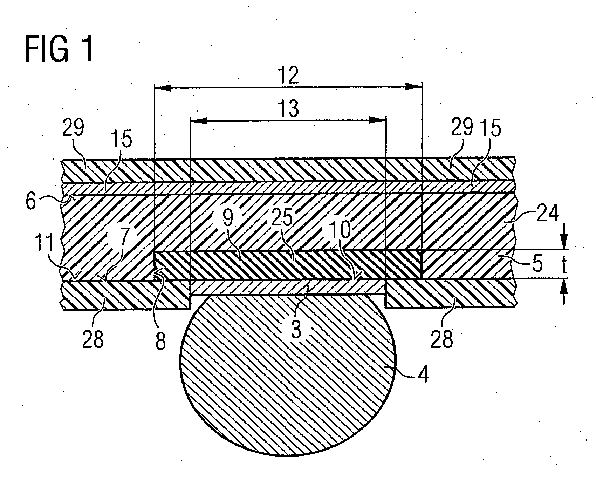

Aus der Druckschrift: "Stress free area array structures for flipchips and chipscale devices" von R. Fillian at all, 14th European micro electronics and packaging conference and exhibition, Friedrichshafen, Deutschland, 23.- 25. Juni 2003 Seiten 308 - 312, sind Flip-Chip-Bauteile, Halbleiterchipgrößengehäuse und BGA-Gehäuse bekannt, die Lotbälle aufweisen, welche über einen luftgefüllten Hohlraum angeordnet sind, wie es dort in Figur 1 gezeigt wird oder über einen mit einem elastischen Material aufgefüllten Hohlraum angeordnet sind. Derartige so genannte "Floating Pad"-Lotbälle erfordern ein sehr komplexes auf eine spezifische militärische Anwendung bezogenes kostenintensives Fertigungsverfahren und sind deshalb für die Massenproduktion ebenfalls nicht geeignet. Im Prinzip werden die Hohlräume oder die mit Elastomer gefüllten Hohlräume durch Aufbringen von zusätzlichen komplexen Schichten auf das Verdrahtungssubstrat realisiert.

Die US 6,399,896 B1 offenbart eine Gehäusestruktur, die Materialien niedriger Elastizitätsmodul an bestimmten Stellen aufweist, um thermisch verursachte Spannung zu reduziert oder vermeiden. Gummielastische Kontaktflächen auf einer leiterplatte werden bereitgestellt.

Aufgabe der Erfindung ist es, ein Verfahren zur Herstellung eines Verdrahtungssubstrats eines Halbleiterbauteils mit Außenkontaktflecken für Außenkontakte zu schaffen, mit dem die Zuverlässigkeit für Bauteile mit Lotbällen als Außenkontakte erhöht werden kann. Außerdem ist es Aufgabe der Erfindung, ein Verfahren anzugeben, das für die Massenfertigung von preiswerten Halbleiterbauteilen geeignet ist.

Diese Aufgabe wird mit dem Gegenstand der unabhängigen Ansprüche gelöst. Vorteilhafte Weiterbildung der Erfindung ergeben sich aus den abhängigen Ansprüchen.

Ein Verdrahtungssubstrat eines Halbleiterbauteils mit Außenkontaktanschlussflecken zum Anbringen von Außenkontakten wird bereitgestellt. Dazu weist das starre Verdrahtungssubstrat eine Unterseite mit einer Verdrahtungsstruktur und eine Oberseite mit Aussparungen auf. In den Aussparungen ist ein gummielastisches Material angeordnet, wobei Außenkontaktanschlussflecken auf dem gummielastischen Material angeordnet sind.

Dieses Verdrahtungssubstrat unterscheidet sich dadurch, dass keine zusätzlichen Schichten auf das Verdrahtungssubstrat aufzubringen sind, sondern vielmehr das Verdrahtungssubstrat selber dazu dient, Aussparungen bereitzustellen, die mit einem entsprechenden gummielastischen Material auffüllbar sind, auf dessen Oberseite metallische Außenkontaktanschlussflecken vorgesehen werden können, die auch ihrerseits starre Außenkontakte aufnehmen dürfen und dennoch den Außenkontakten ermöglichen, auf Druckwechselbelastungen und zyklische thermische Belastungen nachzugeben, indem das gummielastische Material in den Aussparungen zusammengepresst und gedehnt wird und ebenso in der Lage ist, auf Scherbelastungen zu reagieren, indem das gummielastische Material in den Aussparungen Kippbewegungen der metallischen Kontaktanschlussflecken zulässt.

In einer Ausführungsform bildet die Oberseite des gummielastischen Materials mit der Oberseite des Verdrahtungssubstrats eine koplanare Fläche aus. Diese koplanare Fläche hat den Vorteil, dass ohne Übergänge eine beliebige Verdrahtungsstruktur und Zuführungsleitungen, zu Außenkontaktanschlussflecken, zu Kontaktanschlussflecken und/oder zu Durchkontakten mit hoher Präzision und ohne zusätzliche Fertigungsschritte hergestellt werden können.

Die Aussparungen in dem Substrat können durch einfaches Eindrücken von gummielastischen Materialflecken an den für Außenkontakte vorgesehenen Positionen in eine Vorstufe des Substrats bereitgestellt werden. Um dabei eine koplanare Fläche zu erwirken, wird das Substratmaterial der Vorstufe lediglich zu einer zäh viskosen Masse vorgewärmt. Folglich kann das Ausbilden von Aussparungen und das Füllen derselben durch einfache Drucktechnik realisiert werden und benötigt keine aufwendigen lithografischen Beschichtungs-, Justage-, Belichtungs-, Entwicklungs-, Fixierungs- und Montageverfahren.

In einer weiteren Ausführungsform weist das gummielastische Material Silicone, Siliconelastomere und/oder Gele, sowie geschlossenporige weichporöse Materialien auf. Diese Materialien haben den Vorteil, dass sie einerseits die metallischen Außenkontaktanschlussflecken sicher verankern können und zum anderen den Vorteil, dass sie eine Nachgiebigkeit besitzen und somit Ungenauigkeiten und Durchmesserdifferenzen der Lotkugeln ausgleichen können. Darüber hinaus können sie Stöße, Druckwechselbelastungen, sowie Scherbelastungen bei entsprechenden thermischen zyklischen Tests widerstehen.

Dabei ist es relativ unerheblich, welche Form die Aussparungen beim Eindrücken des elastischen Materials in die Oberseite der zäh viskosen Vorstufe des Substratmaterials einnehmen. Es kann sogar von Vorteil sein, dass die Aussparungen eines einzigen Verdrahtungssubstrats unterschiedliche Tiefen aufweisen. Dort wo die Druckwechselbelastung oder die Scherwechselbelastung besonders hoch ist, können tiefere Aussparungen im Substrat vorgesehen werden, indem gummielastische Materialflecken von größerem Volumen vor dem Eindrücken in das zäh viskose Material des Substrats vorbereitet werden.

Ein weiteres Merkmal ist es, dass die flächige Erstreckung der mit gummielastischen Material aufgefüllten Aussparung größer ist als die flächige Erstreckung der metallischen Außenkontaktanschlussflecken. Bei dieser Maßnahme wird die Wirkung des gummielastischen Materials weiter erhöht, da auch eine Nachgiebigkeit zwischen dem Rand der metallischen Kontaktanschlussflecken und dem Rand der Aussparungen gewährleistet ist.

In einer weiteren Ausführungsform weist das Verdrahtungssubstrat Zufuhrleitungen von der Verdrahtungsstruktur zu den Außenkontaktflecken auf. Diese Zufuhrleitungen können im Vergleich zu der flächigen Erstreckung der Außenkontaktflecken kleiner gestaltet werden, sodass sie der Nachgiebigkeit des gummielastischen Materials in den Aussparungen folgen können, ohne zu reißen oder zu brechen.

Außerdem kann das Verdrahtungssubstrat Durchkontakte durch das Verdrahtungssubstrat aufweisen, welche mit den Zufuhrleitungen in Verbindung stehen und somit einen elektrischen Zugriff auf die Außenkontaktanschlussflecken ermöglichen. Da die Elastizität der Durchgangsleitungen nicht so groß ist, dass sie einer gummielastischen Verformung folgen kann, werden diese relativ starren Durchkontakte in der Nachbarschaft der gummielastischen Materialflecken angeordnet. Über die Zufuhrleitungen werden dann diese Durchkontakte mit den Außenkontaktanschlussflächen verbunden.

Eine weitere Möglichkeit die Anwendbarkeit des gummielastischen Materials unter einer Außenkontaktanschlussfläche zu verbreitern liegt darin, leitende Partikel in dem gummielastischen Material unterzubringen. Diese leitenden Partikel müssen einerseits eine hohe Verformbarkeit aufweisen, außerdem eine große Nachgiebigkeit besitzen, und schließlich müssen sie den erwarteten starken Bewegungen der Außenkontaktanschlussflecken nachvollziehen. Für eine derartige Kontaktierungsaufgabe, ohne die gummielastischen Eigenschaften des Materials unterhalb der Außenkontaktanschlussflächen zu beeinträchtigen, sind so genannte "Kohlenstoff-Nanoröhren" geeignet.

Derartige Kohlenstoff-Nanoröhren sind Hohlröhren mit einer einwandigen oder mehrwandigen hexagonalen Anordnung von Kohlenstoffatomen und weisen einen Durchmesser zwischen wenigen Nanometern und einigen hundert Nanometern auf. Da Kohlenstoff-Nanoröhren auf ihrer Länge von zehn Nanometern bis einigen Millimetern keine Korngrenzen besitzen, sind ihre Verformbarkeit und Elastizität und Nachgiebigkeit wesentlich größer als bei Metallpartikeln, die in üblichen elektrisch leitenden Kunststoffverbindungen eingebaut werden. Auch die Strombelastbarkeit der Kohlenstoff-Nanoröhren ist mit 1 x 10⁹ A/cm² wesentlich größer. Darüber hinaus ist aufgrund der fehlenden Korngrenzen die Zugfestigkeit extrem hoch und liegt zwischen 5 x 10¹⁰ Pa bis 5 x 10¹³ Pa um mehrere Größenordnungen höher als bei üblichen Metallpartikeln, sodass eine Unterbrechung der Kontaktfähigkeit, wenn derartige Kohlenstoff-Nanoröhren mit einem gummielastischen Material gemischt werden, äußerst gering.

Für eine weitere Ausführungsform ist es vorgesehen, dass die Außenkontaktanschlussflecken eine Lotbeschichtung eines bleifreien Lötmaterials aufweisen. Dieses bleifreie Lötmaterial verbessert einerseits die Umweltverträglichkeit und erleichtert das Recyceln derartiger Verdrahtungssubstrate und hat darüber hinaus den Vorteil, dass Außenkontakte aus Lotkugeln auf einfachste Weise mit den Außenkontaktanschlussflächen verbunden werden können.

In einer weiteren Ausführungsform ist auf der Verdrahtungsstruktur des Verdrahtungssubstrats ein Halbleiterchip angeordnet, der mit seinen Flipchip-Kontakten direkt mit Kontaktanschlussflächen der Verdrahtungsstruktur verbunden sein kann. Im Falle eines Halbleiterchips mit Kontaktflächen auf der aktiven Oberseite, werden diese mit der Verdrahtungsstruktur über entsprechende Bondverbindungen elektrisch mit der Verdrahtungsstruktur des Verdrahtungssubstrats verbunden. Für die Wirkungsweise und das Zusammenwirken zwischen einer übergeordneten Schaltungsplatine und den Außenkontakten des Halbleiterbauteils ist es nicht entscheidend, ob der Halbleiterchip mit Flipchip-Kontakten oder mit Bondverbindungen ausgestattet ist.

Entscheidend ist lediglich, dass das Substrat, das die Außenkontaktflächen trägt, mit dem Halbleiterchip über die Kunststoffgehäusemasse mechanisch eng verbunden ist, sodass Ausdehnungsunterschiede zwischen dem Halbleitermaterial und der übergeordneten Schaltungsplatine, die üblicherweise aus einem faserverstärkten Epoxidharz besteht, sich auch noch auf die Lotverbindung zwischen dem Verdrahtungssubstrat des Halbleiterbauteils und der übergeordneten Schaltungsplatine auswirkt. Ein gummielastisches Nachgeben der Außenkontaktanschlussflächen kann die mechanische Beanspruchung zwischen Halbleiterbauteil und übergeordneter Schaltungsplatine soweit abmildern, dass die Gefahr eines Fehlkontaktes oder eines Abrisses eines Außenkontaktes vermieden wird.

Ein Verfahren zur Herstellung eines Verdrahtungssubstrats eines Halbleiterbauteils mit Außenkontaktanschlussflecken zum Anbringen von Außenkontakten weist nachfolgende Verfahrensschritte auf. Zunächst wird eine Grundplatte mit Durchkontakten an vorbestimmten Positionen hergestellt, wobei die Grundplatte eine Vorstufe eines Polymerkunststoffes aufweist. Anschließend wird selektiv eine Schicht aus gummielastischem Material auf eine Oberseite der Grundplatte aufgebracht, wobei die Schicht voneinander beabstandete gummielastische Materialflecken aufweist. Danach wird eine Kupferfolie unter Einpressen der gummielastischen Materialflecken mithilfe der Außenkontaktanschlussflecken auf die Vorstufe des Polymerkunststoffes der Grundplatte laminiert. Bei diesem Lami-, nieren wird eine koplanare Grenzfläche zwischen Kupferfolie und Oberseite der Grundplatte ausgebildet. Anschließend kann die Kupferfolie zu Außenkontaktanschlussflächen und Zuführungen zu den Durchkontakten strukturiert werden. Dieses Strukturieren erfolgt über Lithografie- und Ätztechnik. Danach wird der Polymerkunststoff der Grundplatte unter Bilden eines starren freitragenden Verdrahtungssubstrats ausgehärtet.

Dieses Verfahren hat den Vorteil, dass mit relativ groben Auftragstechniken, wie Drucktechniken, die gummielastischen Materialflecken realisiert werden können. Derartige Drucktechniken sind als Strahldrucktechnik, als Siebdrucktechnik oder als Schablonendrucktechnik bekannt und liefern ein Muster von gummielastischen Materialflecken auf der Grundplatte. Die Kupferfolie wird beim Eindrücken dieser gummielastischen Materialflecken in die zäh viskose Kunststoffmasse der Grundplatte durch entsprechende Laminierungswerkzeuge unterstützt. Die Dicke der Kunststofffolie kann deshalb der Dicke der Außenkontaktanschlussflächen entsprechen.

Nach dem Eindrücken der Außenkontaktanschlussflächen bzw. des gummielastischen Materials in das Substrat kann praktisch die Kupferfolie in Zuführungen und Außenkontaktanschlussflächen strukturiert werden. Vor diesem Strukturieren oder auch nach diesem Strukturieren wird der Polymerkunststoff der Grundplatte unter Bilden eines starren freitragenden Verdrahtungssubstrats ausgehärtet. Bei diesem Aushärten vernetzen sich die Kettenmoleküle des Polymers zu einem Raummuster, das mechanisch äußerst stabil ist.

In einem alternativen Verfahren zur Herstellung eines Verdrahtungssubstrats eines Halbleiterbauteils mit Außenkontaktanschlussflecken zum Anbringen von Außenkontakten wird zunächst ebenfalls eine Grundplatte mit Durchkontakten an vorbestimmten Positionen bereitgestellt. Dabei stellt die Grundplatte eine Vorstufe eines Polymerkunststoffes dar. Derartige Vorstufen sind Polymerkunststoffe, die noch nicht vollständig vernetzt sind und somit bei relativ niedrigen Temperaturen einen Erweichungspunkt aufweisen, bei dem die starre Vorstufe eines Polymerkunststoffes in eine zäh viskose Masse übergeht. Bei Raumtemperatur ist diese Vorstufe fest, sodass auf die Grundplatte selektiv eine Schicht aus gummielastischem Material auf die Oberseite der Grundplatte aufgebracht werden kann. Dabei weist die Schicht voneinander beabstandete gummielastische Materialflecken auf, die an vorbestimmten Positionen der Grundplatte angeordnet sind.

Alternativ zum obigen Verfahren wird nun keine Metallfolie auflaminiert, sondern eine kupferkaschierte Folie vorbereitet, deren Metallkaschierung bereits strukturiert ist und metallische Außenkontaktanschlussflecken aufweist. Die Anordnung der Außenkontaktanschlussflecken auf der Folie entspricht der Anordnung der gummielastischen Materialflecken auf der Grundplatte, auf die die strukturierte metallkaschierte Folie nun ausgerichtet wird. Dabei ist es vorteilhaft, wenn das Folienmaterial selbst einen transparenten Kunststoff aufweist, sodass die Ausrichtung erleichtert wird. Anschließend werden beim Laminieren die gummielastischen Materialflecken auf der Oberseite der Grundplatte und die Außenkontaktanschlussflächen in die Vorstufe des Polymerkunststoffes der Grundplatte eingepresst. Dazu wird die Grundplatte auf die Erweichungstemperatur der Vorstufe des Polymerkunststoffes aufgeheizt. Dabei entsteht eine koplanare Grenzschicht zwischen Folie und Oberseite der Grundschicht.

Nach diesem Schritt werden die Außenkontaktanschlussflächen der Außenkontaktflecken freigelegt. Dieses kann einerseits dadurch erfolgen, dass die entsprechenden Bereiche der kupferkaschierten Folie freigelegt werden, indem durch photolithographische Schritte die Trägerfolie an den Stellen der Außenkontaktanschlussflecken aufgelöst wird, oder durch Abziehen der Trägerfolie von der koplanaren Grenzschicht. Abschließend kann der Polymerkunststoff der Grundplatte unter Bilden eines starren freitragenden Verdrahtungssubstrats ausgehärtet werden. Bei diesem Aushärten wird die Vorstufe des Polymerkunststoffes stärker vernetzt und erhält damit eine größere Formstabilität.

Bei einer weiteren Variante des Verfahrens werden die gummielastischen Materialflecken nicht auf der Grundplatte vorbereitet, sondern auf entsprechend vorbereiteten metallischen Außenkontaktanschlussflächen einer strukturierten metallkaschierten und eventuell transparenten Kunststoffträgerfolie aufgebracht. Diese Verbundfolie, die bereits Außenkontaktanschlussflecken und die gummielastischen Materialflecken aufweist, kann dann auf die Oberfläche, unter Eindringen der gummielastischen Materialflecken in die Vorstufe des Polymerkunststoffes der Grundplatte auflaminiert werden. Die transparente Kunststoffträgerfolie kann anschließend nach Aushärten der Grundplatte von der sich bildenden koplanaren Grenzschicht zwischen Folie und Oberseite der Grundplatte abgezogen werden.

In allen drei Verfahrensvarianten entsteht abschließend ein freitragendes Verdrahtungssubstrat, auf dessen Unterseite eine Verdrahtungsstruktur aufgebracht werden kann, die mit den Durchkontakten in Verbindung steht und Bindungen zu einem aufzubringenden Halbleiterchip ermöglicht. Ferner können Lötstopplackschichten sowohl auf der Oberseite als auch auf der Unterseite des freitragenden Verdrahtungssubstrats aufgebracht werden, um lediglich die Außenkontaktanschlussflächen auf der Oberseite und entsprechende Kontaktanschlussflächen für Verbindungen mit den aufzubringenden Halbleiterchips freizulassen. Diese Kontaktanschlussflächen sind unterschiedlich auf dem Verdrahtungssubstrat angeordnet, je nachdem ob ein Halbleiterchip direkt mit seinen Flipchip-Kontakten auf der Verdrahtungsstruktur anzuschließen ist, oder ob ein Halbleiterchip über Bondverbindungen mit dem Verdrahtungssubstrat und der darauf befindlichen Verdrahtungsstruktur zu verbinden ist.

In allen drei Verfahren zum Einpressen der gummielastischen Materialflecken in das Material der Grundplatte wird ein Muster an mit gummielastischen Material gefüllten Aussparungen in dem Verdrahtungssubstrat geschaffen, durch das die Dicke des Verdrahtungssubstrats nicht erhöht wird und keinerlei zusätzliche Beschichtungen des Verdrahtungssubstrats zur Erzeugung eines gummielastischen Bereichs unterhalb eines Außenkontaktanschlussfleckes erforderlich wird.

Mit diesem Verfahren sind durch kostengünstige Verfahrensschritte Verdrahtungssubstrate herstellbar, die keine zusätzlichen, die Dicke des Substrats vergrößernden, gummielastischen Strukturen erfordern, und dennoch wird eine mechanische Entkopplung zwischen Halbleiterbauteil und übergeordneter Schaltungsplatine ermöglicht. Da die Dimensionen der gummielastischen Materialflecken frei wählbar sind, können auch unterschiedliche Tiefen der Aussparungen, die mit gummielastischem Material gefüllt sind, im Verdrahtungssubstrat erreicht werden.

Zusammenfassend ist festzustellen, dass mit dem Verdrahtungssubstrat eines Halbleiterbauteils die Kräfte, die zwischen dem Halbleiterbauteilgehäuse und einer übergeordneten Leiterplatte bzw. Schalungsplatine wirken, besser aufgenommen werden können, weil unterhalb der gehäuseseitigen Außenkontaktanschlussflecken jeweils eine gummielastische Schicht in das Verdrahtungssubstrat integriert ist. Da diese Schicht in den Grundkörper bzw. die Grundplatte des Verdrahtungssubstrats eingebettet ist und dort bereits bei der Substratherstellung an entsprechenden Positionen vorgesehen ist, wird die Herstellung derartiger gummielastischer Muster vereinfacht und somit kostengünstiger.

Die gummielastische Schicht unterhalb der Außenkontaktanschlussflecken erlaubt bei Einwirkung äußerer Kräfte auf den Lotkontakt eine begrenzte Auslenkung, vorzugsweise in Z-Richtung und ermöglicht somit eine Spannungsabsorbtion bzw. eine Dämpfung bei Vibrationsbelastungen. Die Dicke der gummielastischen Schicht kann je nach notwendiger Beanspruchung variiert werden, um so einen optimalen Ausgleich zwischen Robustheit und Flexibilität der Verbindung zu erreichen. Auch innerhalb eines Bauteils kann die Dicke variiert werden, um stärker beanspruchte Kontakte, bspw. Außenkontakte in den Ecken eines Verdrahtungssubstrats, zu entlasten.

Somit ergeben sich zusammenfassend nachfolgende Vorteile:
1. Eine höhere Zuverlässigkeit der Verbindung, insbesondere bei Falltests, die eine Zugbelastung in Z-Richtung bewirken, aber auch bei Temperaturzyklentests auf einer Leiterplattenebene.
2. Ein Ankontaktieren beim Testen wird aufgrund der gummielastisch gelagerten Außenkontaktanschlussflächen verbessert.
3. Für den Endkunden entfällt ein Unterfüllen des Zwischenraums zwischen Halbleiterbauteilgehäuse und übergeordneter Schaltungsplatte, sodass das Anbringen der Halbleiterbauteile mit ihren Außenkontakten auf der übergeordneten Schaltungsplatine einfacher erfolgen kann.
4. Der Herstellungsprozess derartiger gummielastisch abgefederter Außenkontaktanschlussflecken kann kostengünstig erfolgen.

Somit wird eine spannungsabsorbierende Schicht in dem Verdrahtungssubstrat bzw. in einem Substratinterposer innerhalb der Außenkontaktanschlussflecken bzw. der Ballpads geschaffen und damit eine teilweise mechanische Entkoppelung von Gehäuse und übergeordneter Schaltungsplatine erreicht.

Die Erfindung wird nun anhand der beigefügten Figuren näher erläutert.
- Figur 1: zeigt einen schematischen Querschnitt durch einen Abschnitt eines Verdrahtungssubstrats;
- Figur 2: zeigt einen schematischen Querschnitt durch eine Grundplatte einer Vorstufe eines Polymerkunststoffs;
- Figur 3: zeigt einen schematischen Querschnitt durch die Grundplatte gemäß Figur 1 nach Aufbringen von gummielastischen Materialflecken;
- Figur 4: zeigt einen schematischen Querschnitt durch die Grundplatte gemäß Figur 2 nach Aufbringen einer Metallfolie;
- Figur 5: zeigt einen schematischen Querschnitt durch die Grundplatte gemäß Figur 4 nach Eindrücken der gummielastischen Materialflecken in die Grundplatte;
- Figur 6: zeigt einen schematischen Querschnitt der Grundplatte nach Strukturieren der Metallfolie zu Kontaktanschlussflächen und Zuleitungen;
- Figur 7: zeigt einen schematischen Querschnitt durch ein Verdrahtungssubstrat;
- Figur 8: zeigt einen schematischen Querschnitt durch einen Abschnitt eines Halbleiterbauteils einer ersten Ausführungsform, montiert auf eine übergeordnete Schaltungsplatine;
- Figur 9: zeigt einen schematischen Querschnitt durch einen Abschnitt eines Halbleiterbauteils einer zweiten Ausführungsform, montiert auf eine übergeordnete Schaltungsplatine.

Figur 1 zeigt einen schematischen Querschnitt durch einen Abschnitt eines Verdrahtungssubstrats 5. Das Verdrahtungssubstrat 5 weist eine Grundplatte 24 auf, die eine Oberseite 7 und eine Unterseite 6 besitzt. In die Grundplatte 24 ist von der Oberseite 7 aus ein gummielastisches Material 9 eingelegt, das einen gummielastischen Materialfleck 25 bildet und einer Aussparung 8 in der Oberseite 7 des Verdrahtungssubstrats 5 auffüllt.

Der in die Grundplatte 24 eingelassene gummielastische Materialfleck 25 weist eine Oberseite 10 auf, die mit der Oberseite 7 des Verdrahtungssubstrats 5 eine koplanare Fläche 11 ausbildet. Auf der koplanaren Fläche 11 des Verdrahtungssubstrats 5 ist im Bereich der gummielastischen Materialflecken 25 ein metallischer Außenkontaktanschlussfleck 3 angeordnet. Die flächige Erstreckung 13 des Außenkontaktanschlussflecks 3 ist kleiner als die flächige Erstreckung 12 des gummielastischen Materialflecks 25.

Da der gummielastische Materialfleck 25 nachgiebig ist, können Scherbelastungen aufgrund von thermischen Verspannungen oder Vibrationsbelastungen, die auf den Außenkontaktanschlussflecken 3 wirken, abgebaut und/oder gedämpft werden. Dazu kann die Tiefe t der Aussparungen 8 eines Verdrahtungssubstrats 5 eines Halbleiterbauteils an die erwarteten Belastungen angepasst werden, sodass bspw. Eckkontakte mit einer dickeren gummielastischen Schicht als Außenkontakte 4 im Zentrum des Halbleiterbauteils gepuffert werden.

Eine in diesem Querschnitt nicht sichtbare Zufuhrleitung verbindet den Außenkontaktanschlussfleck 3 und damit den auf ihn angebrachten Außenkontakt 4 mit einer Verdrahtungsstruktur 15, die auf der Unterseite 6 des Verdrahtungssubstrats 5 angeordnet ist. Die Oberseite 7 des Verdrahtungssubstrats 5 ist derart mit einer oberen Lötstopplackschicht 28 bedeckt, dass sie die Außenkontaktanschlussflecken 3 freilässt, welche die Außenkontakte 4 tragen. Auf der Unterseite 6 wird die Verdrahtungsstruktur 15 von einer unteren Lötstopplackschicht 29 vor Beschädigungen geschützt. Die Vorteile eines derartigen Verdrahtungssubstrats 5 mit gummielastisch gelagertem Außenkontakt 4 wurden bereits oben erörtert und werden deshalb an dieser Stelle weggelassen.

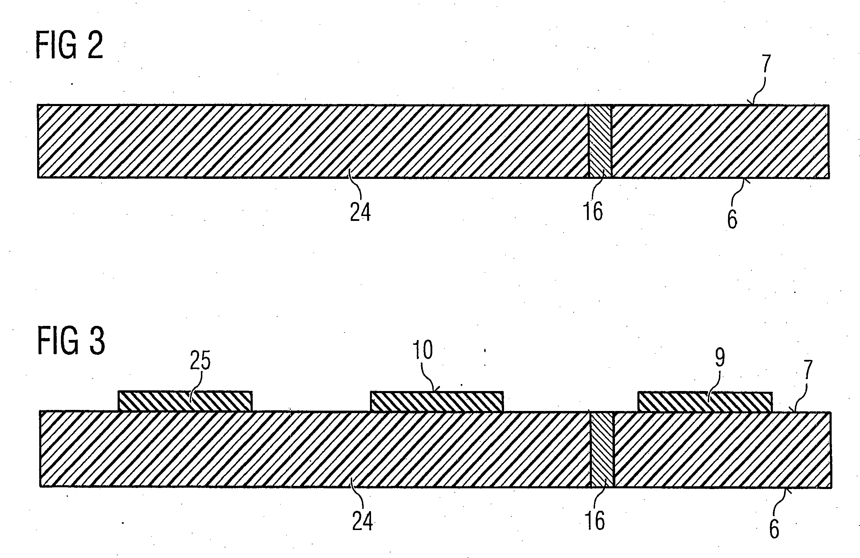

Die Figuren 2 bis 7 zeigen schematische Querschnitte durch einzelne Komponenten bei der Herstellung eines Verdrahtungssubstrats für Halbleiterbauteile. Komponenten mit gleichen Funktionen, wie in Figur 1, werden in den Figuren 1 bis 7 mit gleichen Bezugszeichen gekennzeichnet und nicht extra erörtert. Die Herstellung derartiger Verdrahtungssubstrate kann unabhängig von Halbleiterchipherstellern von Zulieferfirmen übernommen werden, die bisher metallische Flachleiterrahmen geliefert haben.

Figur 2 zeigt einen schematischen Querschnitt durch eine Grundplatte 24 aus einer Vorstufe eines Polymerkunststoffes. Die Grundplatte 24 weist eine Oberseite 7 und eine Unterseite 6 auf. Von der Oberseite 7 zur Unterseite 6 sind Durchkontakte 16 in der Grundplatte 24 an vorgesehenen Positionen angeordnet. Diese Durchkontakte 16 dienen dazu, die herzustellenden Außenkontaktanschlussflecken auf der Oberseite 7 der Grundplatte 24 mit einer herzustellenden Verdrahtungsstruktur auf der Unterseite 6 der Grundplatte 24 zu verbinden.

Figur 3 zeigt einen schematischen Querschnitt durch die Grundplatte 24 gemäß Figur 1 nach Aufbringen von gummielastischen Materialflecken 25. Diese gummielastischen Materialflecken 25 können eine unterschiedliche Dicke aufweisen, um damit unterschiedlich tiefe Aussparungen in der Grundplatte 24, die mit gummielastischem Material 9 gefüllt sind, herzustellen.

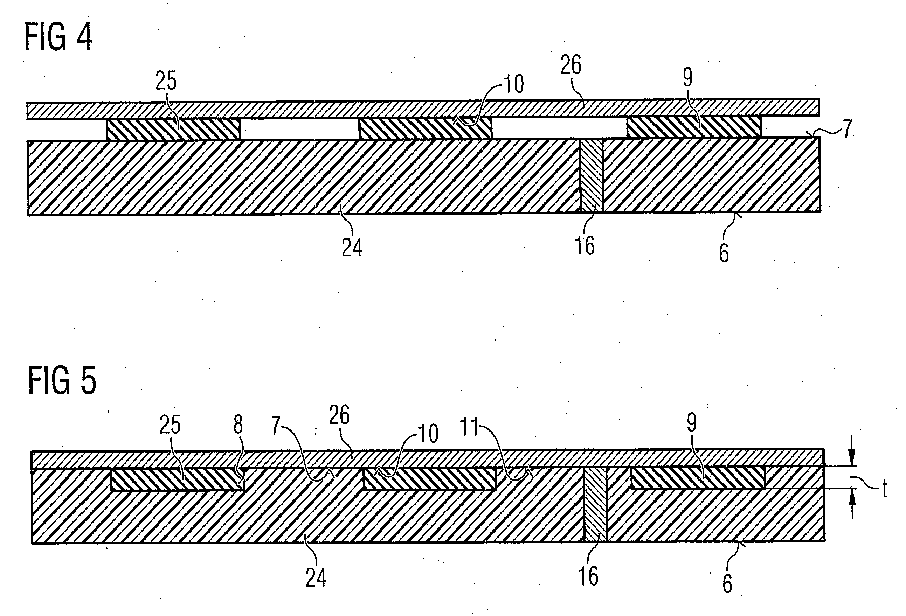

Figur 4 zeigt einen schematischen Querschnitt durch die Grundplatte 24 gemäß Figur 2 nach Aufbringen einer Metallfolie 26. Diese Metallfolie 26 wird aufgebracht, um anschließend auf die Oberfläche 7 der Grundplatte 24 laminiert zu werden. Bei dem Laminierungsvorgang wird die Grundplatte 24 aus einer Vorstufe eines polymeren Kunststoffes zu einer zäh viskosen Masse erwärmt und die Metallfolie 26 unter Einpressen der gummielastischen Metallflecken 25 in die Grundplatte 24 auflaminiert. Dabei wird auch eine Verbindung zwischen dem Durchkontakt 16 und der Metallfolie 26 bereitgestellt.

Figur 5 zeigt einen schematischen Querschnitt durch die Grundplatte 24 gemäß Figur 4 nach Eindrücken der gummielastischen Materialflecken 25 in die Grundplatte 24, wobei eine koplanare Oberfläche 11 aus den Oberseiten 10 der gummielastischen Materialflecken 25 und der Oberseite 7 der Grundplatte 24 entsteht. Bei dem Eindrücken der gummielastischen Materialflecken 25 in die zäh viskose Vorstufe des Polymerkunststoffes der Grundplatte 24 dringen die gummielastischen Metallflecken 25 bis zu einer Tiefe t in die Grundplatte 24 ein. Wenn auch die Tiefe t in diesem Beispiel für die gezeigten drei gummielastischen Metallflecken 25 gleich ist, so kann sie doch, wie oben bereits erwähnt, auch unterschiedlich sein und sich nach der erwarteten Belastung der anzubringenden Außenkontaktanschlussflecken 3 richten.

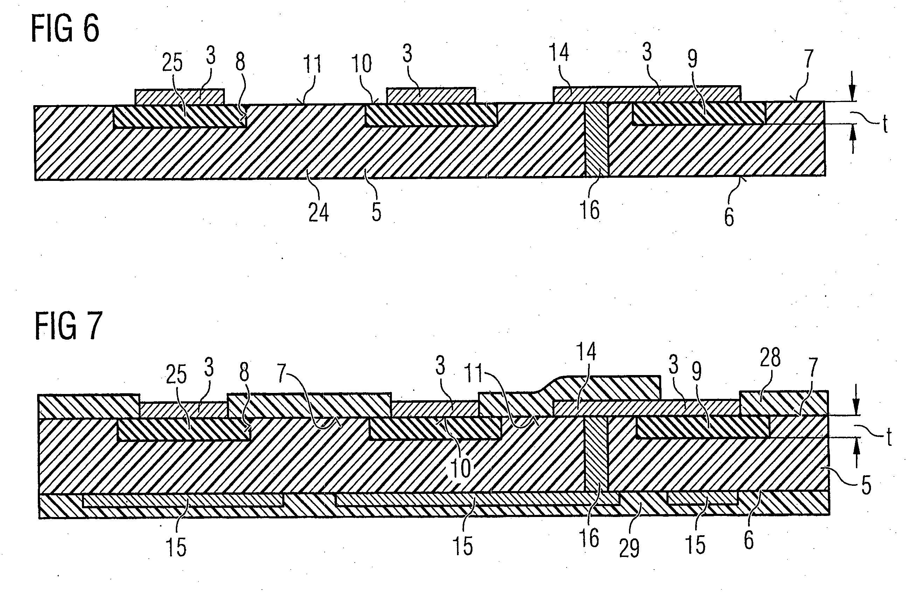

Figur 6 zeigt einen schematischen Querschnitt der Grundplatte 24 nach Strukturieren der Metallfolie 26 der Figur 5 zu Außenkontaktanschlussflecken 3 und Zufuhrleitungen 14. Die Zufuhrleitungen 14 sind schmale Leiterbahnen, welche die Außenkontaktanschlussflecken 3 mit entsprechenden Durchkontakten 16 verbinden, die derart positioniert sind, dass sie die gummielastischen Metallflecken 25 in ihrer Verformbarkeit nicht beeinträchtigen. Um eine hohe Verformbarkeit der gummielastischen Materialflecken 25 zu erreichen, sind diese aus isolierenden Siliconen, Siliconelastomeren, Gelen oder weichporösen isolierenden Materialien hergestellt und für das Leiten des elektrischen Stroms nicht geeignet. In einer Variation der in Figur 6 gezeigten gummielastischen Materialflecken 25 können diese mit entsprechend nachgiebig elektrisch leitfähigen Partikeln, die in der Literatur als Kohlenstoff-Nanoröhren bekannt sind, aufgefüllt sein, sodass Durchkontakte 16 auch unterhalb, d.h. im Bereich der gummielastischen Metallflecken 25, in der Grundplatte 24 vorgesehen werden können.

Figur 7 zeigt einen schematischen Querschnitt durch ein Verdrahtungssubstrat 5 gemäß einer Ausführungsform. Die in Figur 6 gezeigte Vorstufe eines Verdrahtungssubstrats 5 ist durch das Aufbringen einer oberen Lötstopplackschicht 28 auf die Oberseite 7 der Verdrahtungsplatte 5 unter Freilassen der Außenkontaktanschlussflecken 3 komplettiert. Außerdem wird auf die Unterseite 6 die Verdrahtungsstruktur 15 aufgebracht, die ihrerseits durch eine untere Lötstopplackschicht 29 vor Beschädigungen geschützt werden kann. Diese untere Verdrahtungsstruktur 15 dient dazu, über die Durchkontakte 16 die Außenkontaktanschlussflecken 3 auf der Oberseite 7 des Verdrahtungssubstrats mit einem Halbleiterchip auf der Unterseite 6 des Verdrahtungssubstrats elektrisch 5 zu verbinden.

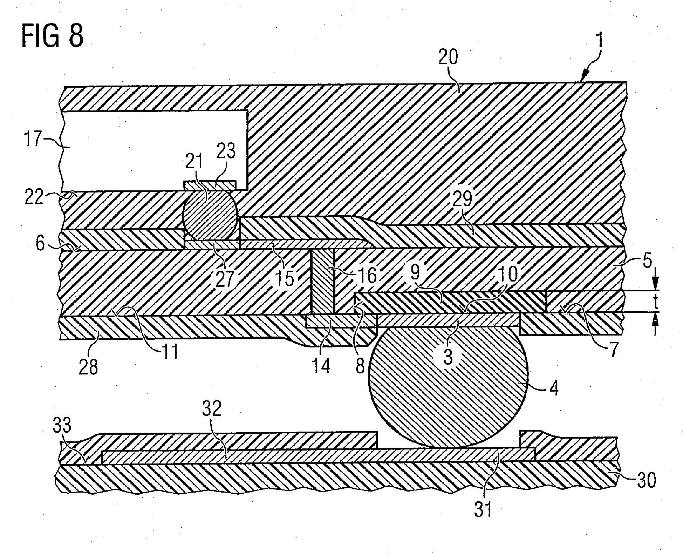

Figur 8 zeigt einen schematischen Querschnitt durch einen Abschnitt eines Halbleiterbauteils 1 einer ersten Ausführungsform, das auf eine übergeordnete Schaltungsplatine 30 montiert ist. Komponenten mit gleichen Funktionen, wie in den vorgehenden Figuren, werden mit gleichen Bezugszeichen gekennzeichnet und nicht extra erörtert. Das Verdrahtungssubstrat 5 mit seinem gummielastisch abgefederten Außenkontaktanschlussfleck 3 weist einen Außenkontakt 4 auf. Dieser Außenkontakt 4 ist über den Außenkontaktanschlussflecken 3 mit einer Zufuhrleitung 14, sowie einem Durchkontakt 16 einer Verdrahtungsstruktur 15 auf der Unterseite 6 des Verdrahtungssubstrats 5 verbunden. Die Verdrahtungsstruktur 15 weist Kontaktanschlussflächen 27 auf, die in diesem Halbleiterbauteil 1 der ersten Ausführungsform mit einem Flipchip-Kontakt 21 eines Halbleiterchips 17 in Verbindung stehen.

Der Außenkontakt 4 ist seinerseits mit einem Lotfleck 31 einer Leiterbahnstruktur 32 auf der Oberseite 33 der übergeordneten Schaltungsplatine 30 verbunden. Durch den, in dem Verdrahtungssubstrat 5 des Halbleiterbauteils 1 eingegrabenen gummielastischen Materialfleck 25 können Druckwechselbelastungen in Form von Vibrationen und Scherbelastungen durch Thermospannungen gummielastisch abgefedert und aufgefangen werden, sodass diese Verbindung zwischen dem Halbleiterbauteil 1 und der übergeordneten Schaltungsplatine 30 über einen derartigen gummielastisch abgefederten Außenkontakt 4 eine höhere Zuverlässigkeit aufweisen.

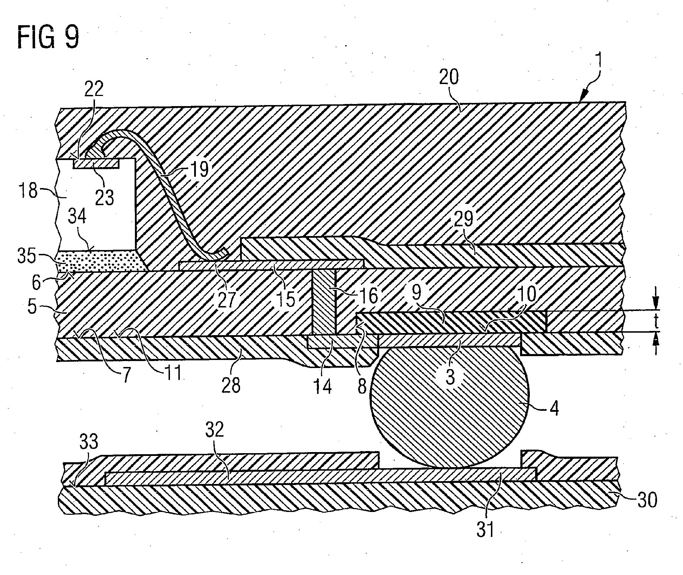

Figur 9 zeigt einen schematischen Querschnitt durch einen Abschnitt eines Halbleiterbauteils 2 einer zweiten Ausführungsform, der auf eine übergeordnete Schaltungsplatine 30 montiert ist. Komponenten mit gleichen Funktionen wie in Figur 8 werden mit gleichen Bezugszeichen gekennzeichnet und nicht extra erörtert.

Diese zweite Ausführungsform eines Halbleiterbauteils 2 unterscheidet sich von dem Halbleiterbauteil, das in Figur 8 gezeigt wird, dadurch, dass die aktive Oberseite 22 des Halbleiterchips 18 Kontaktflächen 23 aufweist, die über eine Bondverbindung 19 mit der Kontaktanschlussfläche 27 der Verdrahtungsstruktur 15 auf der Unterseite 6 des Verdrahtungssubstrats 5 verbunden sind. Darüber hinaus ist die Rückseite 34 des Halbleiterchips 18 über eine Klebstoffschicht 35 mit dem Verdrahtungssubstrat 5 mechanisch verbunden. Der Halbleiterchip 18 mit der Bondverbindung 19, sowie die Strukturen auf der Unterseite 6 des Verdrahtungssubstrats 5 sind von einer Kunststoffgehäusemasse 20 umgeben, die den gesamten Aufbau des Halbleiterbauteils 2 vor Beschädigungen schützt.

## Patentansprüche

1. Verfahren zur Herstellung eines Verdrahtungssubstrats (5) eines Halbleiterbauteils (1, 2) mit Außenkontaktanschlussflecken (3) zum Anbringen von Außenkontakten (4), wobei das Verfahren folgende Verfahrensschritte aufweist:
- Herstellen einer Grundplatte (24) mit Durchkontakten (16) an vorbestimmten Positionen, wobei die Grundplatte (24) eine Vorstufe eines Polymerkunststoffes aufweist,
- Selektives Aufbringen einer Schicht aus gummielastischem Material (9) auf eine Oberseite (7) der Grundplatte (24), wobei die Schicht voneinander beabstandete gummielastische Materialflecken (25) aufweist,
- Laminieren einer Kupferfolie (26) unter Einpressen der gummielastischen Materialflecken (25) mit den Außenkontaktanschlussflecken (3) in die Vorstufe des Polymerkunststoffes der Grundplatte (24) und Bilden einer koplanaren Grenzschicht (11) zwischen Kupferfolie (26) und Oberseite (7) der Grundplatte (24),
- Strukturieren der Kupferfolie (26) zu Außenkontaktanschlussflecken (3) und Zuführleitungen (14) zu den Durchkontakten (16),
- Aushärten des Polymerkunststoffes der Grundplatte (24) unter Bilden eines starren freitragenden Verdrahtungssubstrats (5).

2. Verfahren zur Herstellung eines Verdrahtungssubstrats (5) eines Halbleiterbauteils (1, 2) mit Außenkontaktanschlussflecken (3) zum Anbringen von Außenkontakten (4), wobei das Verfahren folgende Verfahrensschritte aufweist:
- Herstellen einer Grundplatte (24) mit Durchkontakten (16) an vorbestimmten Positionen, wobei die Grundplatte (24) eine Vorstufe eines Polymerkunststoffes aufweist,
- Selektives Aufbringen einer Schicht aus gummielastischem Material (9) auf eine Oberseite (7) der Grundplatte (24), wobei die Schicht voneinander beabstandete gummielastische Materialflecken (25) aufweist,
- Laminieren einer mit Außenkontaktanschlussflecken (3) strukturierten kupferkaschierten Folie unter Ausrichten der Außenkontaktanschlussflecken (3), wobei die Anordnung der Außenkontaktanschlussflecken (3) den gummielastischen Materialflecken (25) entspricht,
- Einpressen der gummielastischen Materialflecken (25) mit den Außenkontaktanschlussflecken (3) in die Vorstufe des Polymerkunststoffes der Grundplatte (24) unter Bilden einer koplanaren Grenzschicht (11) zwischen Folie und Oberseite (7) der Grundschicht (24),
- Freilegen der Außenkontaktanschlussflecken(3),
- Aushärten des Polymerkunststoffes der Grundplatte (24) unter Bilden eines starren freitragenden Verdrahtungssubstrats (5).

3. Verfahren nach Anspruch 1 oder Anspruch 2,
**dadurch gekennzeichnet, dass**
eine obere Lötstopplackschicht (28) unter Freilegen der Außenkontaktanschlussflecken (3) auf die Oberseite (7) des freitragenden Verdrahtungssubstrats (5) aufgebracht wird.

4. Verfahren nach einem der Ansprüche 1 bis 3,
**dadurch gekennzeichnet, dass**
auf die Außenkontaktanschlussflächen (3) eine Lotschicht selektiv aufgebracht wird.

5. Verfahren nach einem der Ansprüche 1 bis 4,
**dadurch gekennzeichnet, dass**
die Unterseite (6) des freitragenden Verdrahtungssubstrats (5) mit einer Verdrahtungsstruktur (15) beschichtet wird.

6. Verfahren nach einem der Ansprüche 1 bis 6,
**dadurch gekennzeichnet, dass**
die Unterseite (6) des freitragenden Verdrahtungssubstrats (5) mit einer Lötstopplackschicht unter Freilassen von Kontaktanschlussflächen (27) der Verdrahtungsstruktur (15) beschichtet wird.

## Claims

1. Method for producing a wiring substrate (5) of a semiconductor component (1, 2) comprising external contact pads (3) for fitting external contacts (4), wherein the method has the following method steps:
- production of a baseplate (24) with through contacts (16) at predetermined positions, wherein the baseplate (24) has a precursor of a polymer plastic,
- selective application of a layer composed of rubber-elastic material (9) to a top side (7) of the baseplate (24), wherein the layer has rubber-elastic material pads (25) that are spaced apart from one another,
- lamination of a copper film (26) with pressing of the rubber-elastic material pads (25) with the external contact pads (3) into the precursor of the polymer plastic of the baseplate (24) and formation of a coplanar boundary layer (11) between copper film (26) and top side (7) of the baseplate (24),
- structuring of the copper film (26) to form external contact pads (3) and feed lines (14) to the through contacts (16),
- curing of the polymer plastic of the baseplate (24) with formation of a rigid self-supporting wiring substrate (5).

2. Method for producing a wiring substrate (5) of a semiconductor component (1, 2) comprising external contact pads (3) for fitting external contacts (4), wherein the method has the following method steps:
- production of a baseplate (24) with through contacts (16) at predetermined positions, wherein the baseplate (24) has a precursor of a polymer plastic,
- selective application of a layer composed of rubber-elastic material (9) to a top side (7) of the baseplate (24), wherein the layer has rubber-elastic material pads (25) that are spaced apart from one another,
- lamination of a copper-coated film structured with external contact pads (3) with alignment of the external contact pads (3), wherein the arrangement of the external contact pads (3) corresponds to the rubber-elastic material pads (25),
- pressing of the rubber-elastic material pads (25) with the external contact pads (3) into the precursor of the polymer plastic of the baseplate (24) with formation of a coplanar boundary layer (11) between film and top side (7) of the base layer (24),
- uncovering of the external contact pads (3),
- curing of the polymer plastic of the baseplate (24) with formation of a rigid self-supporting wiring substrate (5).

3. Method according to Claim 1 or Claim 2,
**characterized in that**
an upper soldering resist layer (28) is applied to the top side (7) of the self-supporting wiring substrate (5) with the external contact pads (3) being uncovered.

4. Method according to one of Claims 1 to 3,
**characterized in that**
a solder layer is applied selectively to the external contact pads (3).

5. Method according to one of Claims 1 to 4,
**characterized in that**
the underside (6) of the self-supporting wiring substrate (5) is coated with a wiring structure (15).

6. Method according to one of Claims 1 to 6,
**characterized in that**
the underside (6) of the self-supporting wiring substrate (5) is coated with a soldering resist layer whilst leaving free contact pads (27) of the wiring structure (15).

## Revendications

1. Procédé de production d'un substrat (5) de câblage d'un composant (1, 2) à semiconducteur, ayant des plages (3) de borne de contacts extérieurs pour appliquer des contacts (4) extérieurs, le procédé ayant les stades de procédé suivants :
- production d'une plaque (24) de base ayant des traversées (16) en des positions définies à l'avance, la plaque (24) de base ayant un précurseur en une matière plastique de polymère,
- dépôt sélectif d'une couche en une matière (9) ayant l'élasticité du caoutchouc sur une face (7) supérieure de la plaque (24) de base, la couche ayant des plages (25) de matière ayant l'élasticité du caoutchouc à distance les unes des autres,
- laminage d'une feuille (26) de cuivre, en enfonçant les plages (25) en matière ayant l'élasticité du caoutchouc avec les plages (3) de borne de contacts extérieurs dans le précurseur de la matière plastique de polymère de la plaque (24) de base et formation d'une couche (11) limite coplanaire entre la feuille (26) de cuivre et la face (7) supérieure de la plaque (24) de base,
- structuration de la feuille (26) de cuivre en des plages (3) de borne de contacts extérieurs et en des lignes (14) menant aux traversées (16),
- durcissement de la matière plastique de polymère de la plaque (24) de base, avec formation d'un substrat (5) de câblage rigide en porte-à-faux.

2. Procédé de production d'un substrat (5) de câblage d'un composant (1, 2) à semiconducteur, ayant des plages (3) de borne de contacts extérieurs pour appliquer des contacts (4) extérieurs, le procédé ayant les stades de procédé suivants :
- production d'une plaque (24) de base ayant des traversées (16) en des positions définies à l'avance, la plaque (24) de base ayant un précurseur en une matière plastique de polymère,
- dépôt sélectif d'une couche en une matière (9) ayant l'élasticité du caoutchouc sur une face (7) supérieure de la plaque (24) de base, la couche ayant des plages (25) de matière ayant l'élasticité du caoutchouc à distance les unes des autres,
- laminage d'une feuille plaquée de cuivre et structurée par des plages (3) de borne de contacts extérieurs, en alignant les plages (3) de borne de contacts extérieurs, l'agencement des plages (3) de borne de contacts extérieurs correspondant aux plages (25) en matière ayant l'élasticité du caoutchouc,
- enfoncement des plages (25) en matière ayant l'élasticité du caoutchouc avec les plages (3) de borne de contacts extérieurs dans le précurseur en la matière plastique de polymère de la plaque (24) de base avec formation d'une couche (11) limite coplanaire entre la feuille et la face (7) supérieure de la couche (24) de base,
- mis à nu des plages (3) de borne de contacts extérieurs
- durcissement de la matière plastique de polymère de la plaque (24) de base, avec formation d'un substrat (5) de câblage rigide en porte-à-faux.

3. Procédé suivant la revendication 1 ou la revendication 2,
**caractérisé en ce que**
on dépose, sur la face (7) supérieure du substrat (5) de câblage en porte-à-faux, une couche (28) de vernis d'arrêt de brasure, en dégageant les plages (3) de borne de contacts extérieurs.

4. Procédé suivant l'une des revendications 1 à 3,
**caractérisé en ce que**
on dépose sélectivement une couche de brasure sur les surfaces (3) de borne de contacts extérieurs.

5. Procédé suivant l'une des revendications 1 à 4,
**caractérisé en ce que**
on revêt la face (6) inférieure du substrat (5) de câblage en porte-à-faux.

6. Procédé suivant l'une des revendications 1 à 5,
**caractérisé en ce que**
on revêt la face (6) inférieure du substrat (5) de câble en porte-à-faux d'une couche de vernis d'arrêt de brasure, en dégageant des surfaces (27) de borne de contacts de la structure (5) de câblage.
